# EUROPÄISCHE PATENTANMELDUNG

(11) **EP 2 605 436 A2**
(43) Veröffentlichungstag der Anmeldung: **19.06.2013**
(21) Anmeldenummer: 12194800.4
(22) Anmeldetag: 29.11.2012
(51) Int. Cl.: H04L 1/00

(54) **Sicherung eines Telegramms über die Positionierung der CRC-Daten**

(30) Priorität: 15.12.2011 DE 102011121142
(71) Anmelder: Siemens Aktiengesellschaft, 80333 München (DE)
(72) Erfinder: Wiesgickl, Bernhard, 92249 Vilseck (DE)

(57) **Zusammenfassung**

Die Erfindung betrifft ein Verfahren zum Senden eines Telegramms von einer Sendevorrichtung an eine Empfangsvorrichtung sowie eine Sendevorrichtung und eine Empfangsvorrichtung. Um eine verbesserte Datenübertragung bereitzustellen, bei welcher insbesondere mit einer minimalen Anzahl von Sicherungsbit möglichst viele Nutzdaten übertragbar sind, wird vorgeschlagen, dass die Sendevorrichtung aus zu übertragenden Nutzdaten und zumindest einem Teil der spezifischen Adresse der Empfangsvorrichtung einen CRC-Wert bildet, welcher innerhalb des zu sendenden Telegramms durch CRC-Daten abgebildet wird, und über die variable Positionierung der CRC-Daten innerhalb des Nutzdatenbereichs des Telegramms eine zusätzliche Information an die Empfangsvorrichtung überträgt.

## Beschreibung

Die Erfindung betrifft ein Verfahren zum Senden eines Telegramms von einer Sendevorrichtung an eine Empfangsvorrichtung sowie eine Sendevorrichtung und eine Empfangsvorrichtung.

Im Bereich der industriellen Automatisierungstechnik können zunehmend Geräte untereinander drahtgebunden oder drahtlos kommunizieren. Zur Kommunikation zwischen den Geräten können unterschiedliche Kommunikationssysteme eingesetzt werden. Bekannte Kommunikationssysteme sind beispielsweise PROFIBUS, PROFINET, Actuator-Sensor-Interface (kurz AS-i). In Abhängigkeit des verwendeten Kommunikationssystems werden unterschiedliche Telegramme zur Kommunikation zwischen den Geräten verwendet. Zur geordneten Kommunikation innerhalb des jeweiligen Kommunikationssystems weisen üblicherweise die Geräte, insbesondere die Slaves, des Kommunikationssystems jeweils eine spezifische Adresse innerhalb des Kommunikationssystems auf. Ein Master (z.B. SPS, AS-i Master) des Kommunikationssystems kann somit über die spezifischen Adressen der Slaves des Kommunikationssystems gezielt ein Telegramm an einen dieser Slaves senden, so dass der adressierte Slave erkennen kann, dass das vom Master gesandte Telegramm für ihn gedacht ist.

Die vorliegende Erfindung wird im Folgenden anhand des Actuator-Sensor-Interface beschrieben. Das erfindungsgemäße Verfahren sowie die erfindungsgemäßen Vorrichtungen können jedoch ebenso bei anderen Kommunikationssystemen, insbesondere im Bereich der industriellen Automatisierungstechnik, angewandt werden.

Im Fall von AS-i kann z.B. die Sendevorrichtung ein AS-i Master oder AS-i Salve und die Empfangsvorrichtung ein AS-i Master oder AS-i Salve sein. Der AS-i Master (Sendevorrichtung) kann mittels eines Telegramms gezielt einen AS-i Slave adressieren und über das Telegramm dem AS-i Slave (Empfangsvorrichtung) Daten senden. Ebenso kann der AS-i Slave als Sendevorrichtung und der AS-i Master als Empfangsvorrichtung tätig sein.

Ein zu sendendes Telegramm umfasst bei AS-i einen Nutzdatenbereich. Im Nutzdatenbereich werden zu übertragende Nutzdaten (z.B. Messwerte, Zustände und/oder Parameter) übertragen.

Damit eine sichere Kommunikation zwischen der Sendevorrichtung und der Empfangsvorrichtung garantiert werden kann, wird das zu sendende Telegramm mit Sicherheitsmechanismen versehen, so dass ein sicheres Telegramm vorliegt. Zum Einen wird das sichere Telegramm mit einer laufenden Nummer versehen. Mittels dieser laufenden Nummer kann die Empfangsvorrichtung kontrollieren ob Telegramme ausgelassen oder eingefügt wurden. Ferner wird das zu sendende Telegramm mit einem CRC-Wert versehen. Der CRC-Wert wird durch eine zyklischen Redundanzprüfung (engl. cyclic redundancy check, kurz CRC) gebildet. Im Fall von AS-i wird über die zu sichernden Nutzdaten, die Adresse der Empfangsvorrichtung und der laufende Nummer des zu sendenden Telegramms von der Sendevorrichtung mittels eines CRC-Wert Berechnungsverfahrens der telegrammspezifische CRC-Wert gebildet. Der gebildete CRC-Wert wird durch CRC-Daten innerhalb des zu sendenden sicheren Telegramms abgebildet. Die CRC-Daten werden neben den zu übertragenden Nutzdaten und der laufenden Nummer innerhalb des Nutzdatenbereichs des sicheren Telegramms an die adressierte Empfangsvorrichtung übertragen. Die Empfangsvorrichtung empfängt dieses sichere Telegramm und berechnet aus ihrer eigenen Adresse und den durch das Telegramm übertragenen Nutzdaten und der laufenden Nummer mit demselben CRC-Wert Berechnungsverfahren, wie die Sendevorrichtung, den CRC-Wert. Durch einen Vergleich des durch die übertragenden CRC-Daten abgebildeten CRC-Werts mit dem selbst berechneten CRC-Wert kann die Empfangsvorrichtung feststellen, ob das übertragene sichere Telegramm korrekt ist. Mittels des CRC-Wertes erfolgt somit eine Fehlerkontrolle des übertragenen sicheren Telegramms seitens der Empfangsvorrichtung.

Im Nutzdatenbereich des sicheren Telegramms werden somit üblicherweise die Nutzdaten, die laufende Nummer und die den CRC-Wert abbildenden CRC-Daten übertragen. Ein Telegrammaufbau kann wie folgt aufgebaut sein: Nutzdaten (n-Bit), laufende Nummer (n-Bit), CRC-Daten (n-Bit). Stehen für den Nutzdatenbereich z. B. 16 Bit im Telegramm zur Verfügung, kann eine Aufteilung wie folgt aussehen: 4 Bit Nutzdaten "ND" (ND1, ND2, ND3, ND4), 4 Bit laufende Nummer "LN" (LN1, LN2, LN3, LN4), 8 Bit CRC-Daten "CRC"(CRC1, CRC2, CRC3, CRC4, CRC5, CRC6, CRC7, CRC8). Das sichere Telegramm würde somit üblicherweise folgende Verteilung innerhalb des 16 Bit Nutzdatenbereichs aufweisen: ND1, ND2, ND3, ND4, LN1, LN2, LN3, LN4, CRC1, CRC2, CRC3, CRC4, CRC5, CRC6, CRC7, CRC8.

Es ist Aufgabe der vorliegenden Erfindung eine verbesserte Datenübertragung bereitzustellen, bei welcher insbesondere mit einer minimalen Anzahl von Sicherungsbit möglichst viele Nutzdaten übertragbar sind. Vorzugsweise soll ferner der Adressbereich der Empfangsvorrichtungen vergrößert werden, ohne dass die Anzahl der Nutzdaten reduziert werden muss.

Diese Aufgaben werden gelöst durch ein Verfahren gemäß Anspruch 1, d.h. durch ein Verfahren zum Senden eines sicheren Telegramms von einer Sendevorrichtung an eine Empfangsvorrichtung, welche eine spezifische Adresse aufweist, wobei das zu sendende Telegramm einen Nutzdatenbereich aufweist, wobei die Sendevorrichtung aus zu übertragenden Nutzdaten und zumindest einem Teil der spezifischen Adresse der Empfangsvorrichtung einen CRC-Wert bildet, welcher innerhalb des zu sendenden Telegramms durch CRC-Daten abgebildet wird, und über die variable Positionierung der CRC-Daten innerhalb des Nutzdatenbereichs des Telegramms eine zusätzliche Information an die Empfangsvorrichtung überträgt, sowie durch eine Sendevorrichtung nach Anspruch 13, d.h. durch eine Sendevorrichtung zum Senden eines sicheren Telegramms an eine Empfangsvorrichtung, welche eine spezifische Adresse aufweist, wobei die Sendevorrichtung dazu ausgebildet ist, aus zu übertragenden Nutzdaten und zumindest einem Teil der spezifischen Adresse der Empfangsvorrichtung einen CRC-Wert zu bilden, welcher innerhalb des zu sendenden sicheren Telegramms durch CRC-Daten abgebildet wird, und über eine variable Positionierung der CRC-Daten innerhalb eines Nutzdatenbereichs des zu sendenden sicheren Telegramms eine zusätzliche Information an die Empfangsvorrichtung zu übertragen und eine Empfangsvorrichtung nach Anspruch 14, d.h. durch eine Empfangsvorrichtung zum Empfangen eines sicheren Telegramms, wobei innerhalb der Empfangsvorrichtung adressabhängige unterschiedliche Positionierungen der CRC-Daten hinterlegt sind, so dass sie über die Position der CRC-Daten innerhalb des Nutzdatenbereichs eines empfangenen sicheren Telegramms eine Fehlerkontrolle der Übertragung des Telegramms durchführen kann.

Vorteilhafte Weiterbildungen der Erfindung sind in den abhängigen Ansprüchen 2 bis 12 angegeben.

Über die Position der CRC-Daten innerhalb des Nutzdatenbereichs ist das zu sendende sichere Telegramms kodiert. Mittels dieser Kodierung, welche der Empfangsvorrichtung bekannt ist, wird eine zusätzliche Information an die Empfangsvorrichtung übertragen. Die zusätzliche Information dient vorzugsweise der Fehlererkennung der Telegrammübertragung.

Die CRC-Berechnung für ein zu sendendes sicheres Telegramm erfolgt vorzugsweise identisch zu dem bisherigen Standardverfahren des Kommunikationssystems. Allerdings werden n-Bit der CRC-Daten beim Senden des sicheren Telegramms nicht fix als Block ans Telegramm angehängt, sondern gezielt innerhalb des sicheren Telegramms positioniert. Hierbei werden vorzugsweise einzelne Bit der CRC-Daten mit anderen Bit des Nutzdatenbereichs - z. B. der Nutzdaten oder der laufenden Nummer - getauscht. Die Bit der CRC-Daten werden somit seitens der Sendevorrichtung gezielt innerhalb des Nutzdatenbereichs des sicheren Telegramms positioniert, so dass hierüber eine Kodierung des sicheren Telegramms erfolgt, welche seitens der Empfangsvorrichtung ausgewertet werden kann. Die Positionierung der einzelnen Bit der CRC-Daten innerhalb des Nutzdatenbereichs des sicheren Telegramms kann beispielsweise in Abhängigkeit der Adresse der adressierten Empfangsvorrichtung erfolgen. Der Empfangsvorrichtung ist die von der Sendevorrichtung gewählte Positionierung der CRC-Daten innerhalb des Nutzdatenbereichs bekannt, so dass sie die CRC-Daten sowie den CRC-Wert rückbilden kann. Erfolgt die Positionierung beispielsweise in Abhängigkeit der Adresse der Empfangsvorrichtung, so ist der Empfangsvorrichtung durch ihre Adresse der von der Sendevorrichtung angewandte Tauschalgorithmus der CRC-Daten bekannt und sie kann diese Tauschung aus seiner Adressinformation wieder rückgängig machen. Die Empfangsvorrichtung führt nun vorzugsweise die Überprüfung der CRC-Daten durch, so dass sie ermitteln kann, ob die CRC-Daten bzw. der CRC-Wert ordnungsgemäß von der Sendevorrichtung positioniert und übertragen wurden oder nicht.

Sind beispielsweise seitens der Sendevorrichtung Fehler bei der Adresse aufgetreten, so stimmen die Bitanordnungen im Telegramm nach dem Rücktausch in der Empfangsvorrichtung nicht mehr überein und die CRC-Überprüfung wird mit hoher Wahrscheinlichkeit Fehler aufdecken und das Telegramm als ungültig kennzeichnen.

In einer vorteilhaften Ausführungsform der Erfindung sind die CRC-Daten innerhalb des Nutzdatenbereichs losgelöst positioniert. D.h. die CRC-Daten sind nicht zusammenhängend innerhalb des Nutzdatenbereichs verteilt. Es liegen mindestens zwei Blöcke an CRC-Daten vor, welche durch mindestens ein Bit (z.B. der Nutzdaten oder der laufenden Nummer) getrennt sind.

In einer weiteren vorteilhaften Ausführungsform der Erfindung umfasst der Nutzdatenbereich des zu sendenden sicheren Telegramms die zu übertragenden Nutzdaten und die CRC-Daten.

In einer weiteren vorteilhaften Ausführungsform der Erfindung sendet die Sendevorrichtung das sichere Telegramm, insbesondere über einen Kommunikationsbus, an die Empfangsvorrichtung.

In einer weiteren vorteilhaften Ausführungsform der Erfindung umfasst das sichere Telegramm eine laufende Nummer und zur CRC-Wert Bildung wird die laufende Nummer des sicheren Telegramms mit einbezogen. Der CRC-Wert wird somit aus den Nutzdaten, der Adresse der Empfangsvorrichtung und der laufenden Nummer gebildet.

In einer weiteren vorteilhaften Ausführungsform der Erfindung nimmt mindestens ein Bit der CRC-Daten eine üblicherweise verwendete Position der laufenden Nummer innerhalb des Nutzdatenbereichs ein.

Da gleiche Bitwerte bei einer Tauschung (z. B. 1 getauscht mit 1) keine Möglichkeit einer Fehleraufdeckung ermöglichen, muss die Aufdeckungswahrscheinlichkeit optimiert werden. Die kann geschehen, wenn die Bit der CRC-Daten ihre Position im Nutzdatenbereich des Telegramms tauschen, die sich durch die laufende Nummer kontinuierlich ändern. Die Nutzdaten eines Telegramms müssen sich nicht in jedem Übertragungszyklus ändern. Folglich kann durch ein gezieltes Positionieren von mindestens einem Bit der CRC-Daten an der im Telegramm üblicherweise verwendeten Position der Bit der laufenden Nummer zu einem optimierten Fehleraufdeckung führen. Dadurch werden mit hoher Wahrscheinlichkeit spätestens nach der nächsten Übertragung eines Telegramms die getauschten Bit unterschiedlich sein.

Vorteilhafterweise wird mindestens ein Bit der CRC-Daten an die Position der laufenden Nummer gesetzt. Das Bit der laufenden Nummer wird somit mit einem Bit der CRC-Daten getauscht. Da die laufende Nummer sich über die gesendeten sicheren Telegramme ändert, kann sichergestellt werden, dass bei gleichbleiben der Nutzdaten über die Zeit keine gleichen Bits innerhalb des sicheren Telegramms getauscht werden.

In einer weiteren vorteilhaften Ausführungsform der Erfindung bildet die Sendevorrichtung aus zu übertragenden Nutzdaten und einem ersten Teil der spezifischen Adresse der Empfangsvorrichtung den CRC-Wert und kodiert den nicht durch den CRC-Wert abgebildeten restlichen Teil der spezifischen Adresse der Empfangsvorrichtung durch die Positionierung der CRC-Daten innerhalb des Nutzdatenbereichs des zu sendenden sicheren Telegramms.

In einer weiteren vorteilhaften Ausführungsform der Erfindung ist die im sicheren Telegramm verwendete Anzahl an Bit für den ersten Teil der spezifischen Adresse gleiche oder kleiner der Anzahl an Bit für die CRC-Daten des sicheren Telegramms.

In einer weiteren vorteilhaften Ausführungsform der Erfindung wird das Verfahren zum Senden des sicheren Telegramms lediglich angewandt, sofern die im Telegramm verwendete Anzahl an Bit für die spezifische Adresse der Empfangsvorrichtung größer als die Anzahl an Bit für die CRC-Daten des Telegramms ist.

In einer weiteren vorteilhaften Ausführungsform der Erfindung führt die Empfangsvorrichtung über die Position der CRC-Daten innerhalb des Nutzdatenbereichs des empfangenen sicheren Telegramms eine Fehlerkontrolle der Übertragung des sicheren Telegramms durch. Liegt eine fehlerhafte Position der CRC-Daten innerhalb des Telegramms vor, so ergibt der Vergleich des durch die Empfangsvorrichtung berechneten CRC-Wertes mit dem durch das Telegramm übertragenden CRC-Wertes einen Fehler.

In einer weiteren vorteilhaften Ausführungsform der Erfindung ist der Empfangsvorrichtung anhand der eigenen Adresse die korrekte Position der CRC-Daten innerhalb des Nutzdatenbereichs im empfangenen sicheren Telegramm bekannt. Die eigene Adresse der Empfangsvorrichtung wird üblicherweise bei der Inbetriebnahme des Kommunikationssystems für die Empfangsvorrichtung vergeben.

In einer weiteren vorteilhaften Ausführungsform der Erfindung ist die Sendevorrichtung und Empfangsvorrichtung ein AS-i Master und/oder ein AS-i Slave.

Im Folgenden wird die Erfindung anhand eines Ausführungsbeispiels näher beschrieben und erläutert. Betrachtet wird ein Kommunikationssystem mit einer Sendevorrichtung und einer Empfangsvorrichtung. Die Empfangsvorrichtung weist eine spezifische Adresse innerhalb des Kommunikationssystems auf und kann gezielt von der Sendevorrichtung adressiert werden. Die Sendevorrichtung (z.B. ein AS-i Master) kann somit gezielt ein sicheres Telegramm an die Empfangsvorrichtung (z.B. AS-i Slave) senden. Eine Kommunikation vom AS-i Slave zum AS-i Master wäre ebenso denkbar.

Zur Datenübertragung steht der Sendevorrichtung innerhalb des Telegramms ein Nutzdatenbereich mit einer Nutzdatenbreite von 16 Bit zur Verfügung. Über diesen Nutzdatenbereich können Daten von der Sendevorrichtung an die Empfangsvorrichtung gesendet werden. Zur sicheren Datenübertragung umfasst der Nutzdatenbereich: Nutzdaten "ND" (4 Bit), eine laufende Nummer "LN" (4 Bit) und CRC-Daten "CRC" (8 Bit).

Der CRC-Wert der CRC-Daten eines zu sendenden Telegramms wird anhand der laufenden Nummer, der Nutzdaten und der Adresse der zu adressierenden Empfangsvorrichtung durch die Sendevorrichtung gebildet. Fehler in 8 Bit einer Adresse einer Empfangsvorrichtung sind üblicherweise durch 8 Bit an CRC-Daten sicher aufdeckbar. Weist die Adresse der Empfangsvorrichtung jedoch mehr als 8 Bit auf, so kann diese nicht mehr sicher durch 8 Bit an CRC-Daten abgebildet werden. Die Anzahl der Bits für die CRC-Daten müsste erhöht werden. Hierfür müsste jedoch die zur Verfügung stehende Anzahl an Bits der Nutzdaten reduziert werden, was nicht wünschenswert ist.

Dadurch, dass innerhalb des Kommunikationssystems die CRC-Daten innerhalb des Nutzdatenbereichs eines sicheren Telegramms gezielt variabel positioniert werden, kann eine zusätzliche Informationsübertragung im sicheren Telegramm erfolgen. Eine sichere Kommunikation mit Empfangsvorrichtungen mit einer Adresse größer als 8 Bit kann somit ermöglicht werden. Das sichere Telegramm wird somit über die Positionierung der CRC-Daten innerhalb des Nutzdatenbereichs zusätzlich kodiert.

Fehler in 8 Bit einer Adresse sind durch eine 8 Bit CRC sicher aufdeckbar. Weist die Erweiterungsvorrichtung jedoch eine 9 Bit Adresse auf, so kann die Sendevorrichtung einen CRC-Wert mittels 8 Bit der 9 Bit Adresse, der laufenden Nummer und der Nutzdaten bilden. In Abhängigkeit der für die CRC-Wert Berechnung nicht betrachteten 1 Bit der Adresse erfolgt eine spezifische Positionierung der CRC-Daten innerhalb des Nutzdatenbereichs. Die Empfangsvorrichtung kennt ihre eigene Adresse, so dass ihr die adressspezifische Positionierung der CRC-Daten bzw. der Tauschalgorithmus der CRC-Daten der Sendevorrichtung bekannt ist. Die Empfangsvorrichtung kann somit aus dem empfangenen sicheren Telegramm die CRC-Daten ermitteln. Dadurch, dass die CRC-Daten gezielt innerhalb des Nutzdatenbereichs des gesendeten Telegramms platziert werden, kann eine zusätzliche Informationsübertragung über ein gesendetes sicheres Telgramm erfolgen.

Zur weiteren Verbesserung der Fehleraufdeckungswahrscheinlichkeit können auch mehr als 1 Bit an CRC-Daten als Gruppen innerhalb des Nutzdatenbereichs des sicheren Telegramms getauscht werden.

Da es für große Adressbereiche von Empfangsvorrichtungen nicht ausreichend viele unterschiedliche Tauschkombinationen innerhalb des Nutzdatenbereichs des Telegramms gibt, ist es am günstigsten den Tauschalgorithmus in Blöcken mit Adressbereichen mit maximal gleich vielen Adressbit wie die CRC-Länge durchzuführen. Z.B. 8 Bit CRC = 8 Bit Adresse = Block 1 ohne Tausch der Bitpositionen innerhalb des sicheren Telegramms für den Adressbereich 0 bis 255 der Empfangsvorrichtungen, Block 2 mit 1. Tauschalgorithmus für die Adressen 256 bis 511 der Empfangsvorrichtungen, usw.).

Folgendes Beispiel zeigt, wie durch die gezielte Positionierung der CRC-Daten innerhalb des Nutzdatenbereichs sichere Telegramme an Empfangsvorrichtungen mit bis zu 10 Bit Adressen gesandt werden können, ohne dass die Anzahl der Bits für die Nutzdaten und die laufende Nummer reduziert werden muss. Die binäre Darstellung der Adresse der Empfangsvorrichtung ist wie folgt aufgebaut: D9 D8 D7 D6 D5 D4 D3 D2 D1 D0. Die Nutzdatenbereite des sicheren Telegramms beträgt 16 Bit. Je Telegramm können 4 Bit Nutzdaten "ND" (ND1, ND2, ND3, ND4), 4 Bit laufende Nummer "LN" (LN1, LN2, LN3, LN4), 8 Bit CRC-Daten "CRC" (CRC1, CRC2, CRC3, CRC4, CRC5, CRC6, CRC7, CRC8) übertragen werden.

Für die Adressen 0 bis 255 der Empfangsvorrichtungen ist die Positionierung der einzelnen Bits der Daten des Nutzdatenbereichs wie folgt: ND1, ND2, ND3, ND4, LN1, LN2, LN3, LN4, CRC1, CRC2, CRC3, CRC4, CRC5, CRC6, CRC7, CRC8

Für die Adressen 256 bis 511 der Empfangsvorrichtungen ist die Positionierung der einzelnen Bits der Daten des Nutzdatenbereichs wie folgt: **CRC1, CRC2,** ND3, ND4, LN1, LN2, LN3, LN4, **ND1, ND2,** CRC3, CRC4, CRC5, CRC6, CRC7, CRC8

Für die Adressen 512 bis 767 der Empfangsvorrichtungen ist die Positionierung der einzelnen Bits der Daten des Nutzdatenbereichs wie folgt: ND1, ND2, **CRC1, CRC2,** LN1, LN2, LN3, LN4, **ND3, ND4,** CRC3, CRC4, CRC5, CRC6, CRC7, CRC8

Für die Adressen 768 bis 1023 der Empfangsvorrichtungen ist die Positionierung der einzelnen Bits der Daten des Nutzdatenbereichs wie folgt: ND1, ND2, ND3, ND4, **CRC1, CRC2,** LN3, LN4, **LN1, LN2,** CRC3, CRC4, CRC5, CRC6, CRC7, CRC8

Durch die 8 Bit an CRC-Daten (CRC1-CRC8) können die ersten 8 Bit der Adresse (D0-D7) gesichert werden. Die beiden verbleibenden 2 Bit werden durch die Position der CRC-Bit im Nutzdatenbereich des Telegramms kodiert und dadurch gesichert. Sind D8 und D9 = 0 ergibt sich folgende binäre Darstellung der Adresse: 0 0 D7 - D0. Dies entspricht einen Adressbereich von 0 bis 255, so dass eine oben dargestellte kodierte Anordnung der CRC-Daten innerhalb des Nutzdatenbereichs erfolgt.

Sind D8 = 1 und D9 = 0 ergibt sich folgende binäre Darstellung der Adresse: 0 1 D7 - D0. Dies entspricht einem Adressbereich von 256 bis 511, so dass eine oben dargestellte kodierte Anordnung der CRC-Daten innerhalb des Nutzdatenbereichs erfolgt.

Sind D8 = 0 und D9 = 1 ergibt sich folgende binäre Darstellung der Adresse: 1 0 D7 - D0. Dies entspricht einem Adressbereich von 512 bis 767, so dass eine oben dargestellte kodierte Anordnung der CRC-Daten innerhalb des Nutzdatenbereichs erfolgt.

Sind D8 = 1 und D9 = 1 ergibt sich folgende binäre Darstellung der Adresse: 1 1 D7 - D0. Dies entspricht einem Adressbereich von 768 bis 1023, so dass eine oben dargestellte kodierte Anordnung der CRC-Daten innerhalb des Nutzdatenbereichs erfolgt.

Die Positionierung macht die Sendevorrichtung vor dem Versenden. Der Empfangsvorrichtung ist die 10 Bit Adresse (und damit auch D8 und D9) bekannt und ändert die Position der CRC-Daten gemäß obiger Darstellung wieder zurück.

Beispiel: D8 = 1 und D9 = 0 (Adressen 256 - 511). Die Empfangsvorrichtung tauscht die Bitposition CRC1 mit ND1 und CRC2 mit ND2 und rechnet dann den CRC-Wert nach. Bei einer Adressvertauschung, die die Bit D0 bis D7 betrifft wird dies direkt durch die CRC-Nachrechnung aufgedeckt. Falsche Rückpositionierungen von D8 und D9 werden ebenso detektiert, da dies zu fehlerhaften CRC-Daten führt. Sind die getauschten Bits zufälligerweise gleich, so wird der Fehler vermutlich bereits nach 2 Übertragungen detektiert, da sich die laufende Nummer fortlaufend ändert.

Durch die Kodierung des Telegramms durch die gezielte Positionierung der CRC-Daten innerhalb des Nutzdatenbereichs eines zu sendenden Telegramms in Abhängigkeit der Adresse der Empfangsvorrichtung kann somit eine zusätzliche Information über das Telegramm übertragen werden, so dass eine verbesserte Kommunikation zwischen der Sendevorrichtung und der Empfangsvorrichtung bereitgestellt werden kann.

Anstelle des CRC-Wertes sind ebenso andere Sicherungsbits denkbar. Derartige Sicherungsbits sind vorzugsweise ebenso von der Erfindung umfasst. Unter den Begriff CRC-Wert werden vorzugsweise ebenso andere Sicherungswerte gesehen, so dass mittels CRC-Daten auch andere Sicherungsbits abgebildet sein können.

## Patentansprüche

1. Verfahren zum Senden eines sicheren Telegramms von einer Sendevorrichtung an eine Empfangsvorrichtung, welche eine spezifische Adresse aufweist, wobei das zu sendende sichere Telegramm einen Nutzdatenbereich aufweist, wobei die Sendevorrichtung aus zu übertragenden Nutzdaten und zumindest einem Teil der spezifischen Adresse der Empfangsvorrichtung einen CRC-Wert bildet, welcher innerhalb des zu sendenden sicheren Telegramms durch CRC-Daten abgebildet wird, und über die variable Positionierung der CRC-Daten innerhalb des Nutzdatenbereichs des sicheren Telegramms eine zusätzliche Information an die Empfangsvorrichtung überträgt.

2. Verfahren nach Anspruch 1, wobei die CRC-Daten innerhalb des Nutzdatenbereichs losgelöst positioniert sind.

3. Verfahren nach einem der vorhergehenden Ansprüche, wobei der Nutzdatenbereich des zu sendenden sicheren Telegramms die zu übertragenden Nutzdaten und die CRC-Daten umfasst.

4. Verfahren nach einem der vorhergehenden Ansprüche, wobei die Sendevorrichtung das sichere Telegramm, insbesondere über einen Kommunikationsbus, an die Empfangsvorrichtung sendet.

5. Verfahren nach einem der vorhergehenden Ansprüche, wobei das sichere Telegramm eine laufende Nummer umfasst und zur CRC-Wert Bildung die laufende Nummer des sicheren Telegramms mit einbezogen wird.

6. Verfahren nach Anspruch 5, wobei mindestens ein Bit der CRC-Daten eine üblicherweise verwendete Position der laufenden Nummer innerhalb des Nutzdatenbereichs einnimmt.

7. Verfahren nach einem der vorhergehenden Ansprüche, wobei die Sendevorrichtung aus zu übertragenden Nutzdaten und einem ersten Teil der spezifischen Adresse der Empfangsvorrichtung den CRC-Wert bildet und den nicht durch den CRC-Wert abgebildeten restlichen Teil der spezifischen Adresse der Empfangsvorrichtung durch die Positionierung der CRC-Daten innerhalb des Nutzdatenbereichs des zu sendenden sicheren Telegramms kodiert.

8. Verfahren nach Anspruch 7, wobei die im sicheren Telegramm verwendete Anzahl an Bit für den ersten Teil der spezifischen Adresse gleiche oder kleiner der Anzahl an Bit für die CRC-Daten des sicheren Telegramms ist.

9. Verfahren nach einem der vorhergehenden Ansprüche, wobei das Verfahren zum Senden des sicheren Telegramms lediglich angewandt wird, sofern die im Telegramm verwendete Anzahl an Bit für die spezifische Adresse der Empfangsvorrichtung größer als die Anzahl an Bit für die CRC-Daten des Telegramms ist.

10. Verfahren nach einem der vorhergehenden Ansprüche, wobei die Empfangsvorrichtung über die Position der CRC-Daten innerhalb des Nutzdatenbereichs des empfangenen sicheren Telegramms eine Fehlerkontrolle der Übertragung des sicheren Telegramms durchführt.

11. Verfahren nach einem der vorhergehenden Ansprüche, wobei der Empfangsvorrichtung anhand der eigenen Adresse die korrekte Position der CRC-Daten innerhalb des Nutzdatenbereichs im empfangenen sicheren Telegramm bekannt ist.

12. Verfahren nach einem der vorhergehenden Ansprüche, wobei die Sendevorrichtung und Empfangsvorrichtung ein AS-i Master und/oder ein AS-i Slave ist.

13. Sendevorrichtung zum Senden eines sicheren Telegramms an eine Empfangsvorrichtung, welche eine spezifische Adresse aufweist, wobei die Sendevorrichtung dazu ausgebildet ist, aus zu übertragenden Nutzdaten und zumindest einem Teil der spezifischen Adresse der Empfangsvorrichtung einen CRC-Wert zu bilden, welcher innerhalb des zu sendenden sicheren Telegramms durch CRC-Daten abgebildet wird, und über eine variable Positionierung der CRC-Daten innerhalb eines Nutzdatenbereichs des zu sendenden sicheren Telegramms eine zusätzliche Information an die Empfangsvorrichtung zu übertragen.

14. Empfangsvorrichtung zum Empfangen eines sicheren Telegramms, wobei innerhalb der Empfangsvorrichtung adressabhängige unterschiedliche Positionierungen der CRC-Daten hinterlegt sind, so dass sie über die Position der CRC-Daten innerhalb des Nutzdatenbereichs eines empfangenen sicheren Telegramms eine Fehlerkontrolle der Übertragung des Telegramms durchführen kann.
